# EUROPÄISCHE PATENTSCHRIFT

(11) **EP 0 332 116 B1**
(45) Veröffentlichungstag und Bekanntmachung des Hinweises auf die Patenterteilung: **14.07.1993**
(21) Anmeldenummer: 89103913.3
(22) Anmeldetag: 06.03.1989
(51) Int. Cl.: H01L 33/00, H01S 3/23, G02B 6/12

(54) **Verfahren zum monolithischen Herstellen von stirnflächenkoppelbaren optoelektronischen und/oder optischen Bauelementen mit Stegwellenleiterstruktur**
Method for the monolithic production of facially connectible opto-electronic and/or optical elements with a ridge waveguide structure
Procédé pour la fabrication monolithique d'éléments opto-électroniques et/ou optiques couplables par la tranche avec une structure de guide d'onde à nervure

(30) Priorität: 09.03.1988 DE 3807777
(43) Veröffentlichungstag der Anmeldung: 13.09.1989
(73) Patentinhaber: SIEMENS AKTIENGESELLSCHAFT, 80333 München (DE)
(72) Erfinder: Muschke, Markus, Dipl.-Ing., D-8011 Brunnthal-Faistenhaar (DE)

(56) Entgegenhaltungen:
- LASER UND OPTOELECTRONIK, Band 16, Nr. 3, September 1984, Seiten 176-186, Stuttgart, DE; K.J. EBBELING: "Abstimmbare, monomode emittierende Halbleiterlaser"
- PATENT ABSTRACTS OF JAPAN, Band 10, Nr. 27 (E-378)[2084], 4. Februar 1986; & Jp-A-60 187 078
- ELECTRONICS LETTERS, Band 21, Nr. 25/26, Dezember 1985, Seiten 1209-1210, Stevenage, Herts, GB; L.A. KOSZI et al.: "1.3 mumInP/InGaAsP channelled-substrate buried-heterostructure laser monolithically integrated with a photodetector"
- JOURNAL OF OPTICAL COMMUNICATIONS, Band 6, Nr. 2, Juni 1985, Seiten 42,43, Berlin, DE; G. MÜLLER et al.: "Fabrication and characteristics of MCRW GaAs/GaALAs lasers on semiinsulating substrate"
- JOURNAL OF VACUUM SCIENCE AND TECHNOLOGY B, Band 3, Nr. 3, Mai/Juni 1985, Seiten 884-888, American Vacuum Society, New York, US; H. YAMADA et al.: "Anisotropic reactive ion etching technique of GaAs and ALGaAs materials for integrated optical device fabrication"

## Beschreibung

Die Erfindung betrifft ein Verfahren zum monolithischen Herstellen von stirnflächenkoppelbaren optoelektronischen und/oder optischen Bauelementen mit Stegwellenleiterstruktur nach dem Oberbegriff des Anspruchs 1.

Zur effizienten Herstellung von optischen Bauelementen und optoelektronischen Halbleiterbauelementen ist die gemeinsame Fertigstellung einer möglichst großen Anzahl von identischen Bauelementen auf einem Plättchen (Wafer bzw. Chip) aus einem geeigneten Material, z.B. Halbleitermaterial oder Lithiumniobat (LiNbO₃), erforderlich. Im Falle von kantenemittierenden Stegwellenleitern, wie z. B. MCRW (metal cladded ridge waveguide)-Laserdioden, bedeutet das, daß sämtliche Technologieschritte auf dem Plättchen, das in diesem Fall aus Halbleitermaterial besteht, vorgenommen werden sollten. Dazu gehört auch die komplexe Prozedur zur Herstellung der emittierenden Kanten, wie z. B. der Laserspiegel, und insbesondere des Stegwellenleiters selbst.

Bisher konnte dieses Problem nicht unter Verwendung einer monolithischen Technologie gelöst werden, da bei den bekannten Technologien zum Herstellen derartiger Bauelemente immer unbeabsichtigte Mißgestaltungen an den lichtemittierenden Kanten bzw. Spiegeln der Bauelemente auftraten, die einen regulären Betrieb und das Erreichen einer akzeptablen Ausbeute sehr erschwerten bzw. unmöglich machten. Aus diesem Grund werden die lichtemittierenden Kanten von Stegwellenleitern bisher durch Brechen entlang der für diesen Zweck geeigneten (materialspezifischen) Kristallachse hergestellt.

Aus dem Dokument "K.J. Ebeling, Laser und Optoelektronik, Band 16, Nr. 3, Sept. 1984, Seiten 176 bis 186" ist bekannt, daß es schwierig ist, einen feinen trennenden Spalt in Zweielementlasern monolithisch herzustellen. Erst durch den Einsatz neuartiger anisotroper wäßriger Ätzverfahren und zusätzlicher recht aufwendiger Plasmaätzverfahren gelingt es, einen genügend tiefen Spalt mit recht glatten Wänden herzustellen.

Inzwischen ist es möglich, Laserdioden in monolithischer Technologie auf einem Halbleiterplättchen zu realisieren. Zur Herstellung der als Laserresonator dienenden planparallelen Endflächen (Laserspiegel) wird die zu schützende Halbleiteroberfläche mit einem Fotolack der gewünschten geometrischen Struktur bedeckt. Durch einen Trockenätzprozeß erhält man die gewünschte Spiegelstruktur auf dem Halbleiterplättchen, wobei die Seitenwände der entstandenen Ätzgräben zum Teil die kantenemittierenden Flächen bzw. Laserspiegel bilden.

Der Erfindung liegt die Aufgabe zugrunde, ein Verfahren zum Herstellen von stirnflächenkoppelbaren optoelektronischen und/oder optischen Bauelementen mit Stegwellenleiterstruktur der eingangs genannten Art zu schaffen, bei dem sowohl die lichtkoppelnden Kanten des Bauelementes als auch die Stegwellenleiter durch monolithische Technologie realisierbar sind, und das nicht nur eine kostengünstige Herstellung kantenemittierender Optobauelemente ermöglicht, sondern zudem eine Integration der kantenemittierenden Stegwellenleiter mit weiteren optischen und/oder elektronischen Komponenten auf einem Plättchen aus geeignetem Material zuläßt.

Diese Aufgabe wird erfindungsgemäß mit den Merkmalen des Anspruchs 1 gelöst.

Vorteilhafte Ausgestaltungen und Weiterbildungen der Erfindung sind Gegenstand zusätzlicher Ansprüche.

Mit dem erfindungsgemäßen Verfahren lassen sich nicht nur sehr kostengünstig stirnflächenkoppelbare optoelektronische und/oder optische Bauelemente herstellen sondern es lassen sich zudem kantenemittierenden Stegwellenleiter mit elektronischen Komponenten auf dem Wafer verknüpfen. Die Stegwellenleiter können dabei sowohl die Gestalt von Vertiefungen als auch von Erhebungen haben.

Mit dem erfindungsgemäßen Verfahren wird insbesondere ermöglicht, zusätzlich zur Spiegelstruktur eine Stegwellenleiterstruktur in eine Halbleiterscheibe (Wafer) zu ätzen. Zu diesem Zweck wird nach einer ganzflächigen Präparation der Waferoberfläche die Fotolackmaske für die Ätzung des Spiegels bzw. der lichtaussendenden Kanten auf den Waver aufgebracht. Die Präparation der Scheibenoberfläche ist selbstverständlich vom zu prozessierenden Bauelement abhängig. Beim MCRW-Laser wären das z. B. eine ganzflächige Kontaktdiffusion und eine erste p-Kontaktmetallisierung.

Nach der Trocken- oder Naßstrukturierung und der evtl. notwendigen Beschichtung der geätzen Flächen, die möglichst eben und senkrecht zur Waveroberfläche sein müssen, werden die durch die Ätzung entstandenen Spiegelgräben mit einem geeigneten Fotolack zugedeckt. Der Fotolack außerhalb des Spiegelgrabens wird belichtet und wegentwickelt. Dabei wird die wesentliche Erkenntnis ausgenutzt, daß die Fotolackschicht nicht unbedingt mit der Waveroberfläche im Grabenbereich eine geschlossene Oberfläche bilden muß. Es genügt vielmehr, wenn der Spiegelgraben von der Fotolackschicht mindestens nahezu, d.h. ungefähr zu mindestens 80 % ausgefüllt ist. Anschließend wird der erste Fotolack ausgeheizt, und zwar bei Temperaturen, welche ihn zwar lichtunempfindlich, aber nicht chemisch unlöslich, zweckmäßig acetonlöslich, machen. Daraufhin wird ein geeigneter zweiter Fotolack über den ersten aufgetragen. Dieser wird mit einer Stegwellenleiterfotomaske belichtet. Nachdem der Fotolack entwickelt ist, liegt eine auch im Speigelbereich einwandfreie Stegwellenleiterätzmaske vor. Nun werden die Waver wieder einer Strukturierungs- und möglicherweise einer Passivierungsprozedur unterzogen. Das Ergebnis ist im besonderen Falle eines MCRW-Lasers ein einwandfreier monolithisch prozessierter Stegwellenleiter, der in einen monolithischen hergestellten Spiegel mündet.

Später kann z. B. mittels einer Abhebetechnik noch eine Metallisierung aufgetragen werden. Nach einer solchen zweiten Metallisierung würde nun im Falle der monolithischen MCRW-Laserstechnologie der vollständige p-Kontakt auf dem Waver vorliegen. Die restlichen Technologieschritte entsprechen dem allgemeinen Stand der Technik.

Bei der Vereinzelung der Bauelemente findet vorzugsweise ein Verfahren Anwendung, das Gegenstand einer älteren deutschen Patentanmeldung (DE-OS 37 31 312) ist. Dabei werden zum Vereinzeln der Bauelemente die zu schützenden Teile des Plättchens, insbesondere Halbleiterplättchens, mit einer Maskierung versehen. Danach wird in die Bodenfläche der Ätzgräben naßchemisch oder trockenätztechnisch eine weitere Grabenvertiefung eingeätzt. Anschließend werden die Bauelemente durch Brechen direkt oder nach einem Zusatzschritt, wie Anritzen, Grabenätzen oder Sägen, vereinzelt. Als Naßätzmittel wird vorzugsweise eine 3:1:1-Ätze der Zusammensetzung 3H₂SO₄: 1H₂O₂: 1H₂O und/oder als Trockenätzmittel ein Chlorplasma verwendet.

Anhand eines in den FIG der Zeichnung als bevorzugtes Ausführungsbeispiel dargestellten MCRW-Lasers wird das erfindungsgemäße Verfahren näher erläutert. Es zeigen:

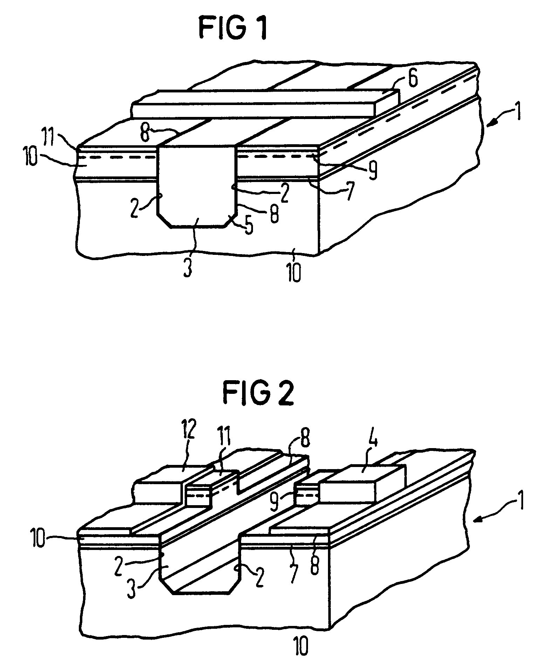

FIG 1 einen Ausschnitt der Laserstruktur nach der ersten Ätzung und FIG 2 die komplett geätzte Laserstruktur mit p-Kontakt.

Zum Herstellen des kantenemittierenden optoelektronischen Halbleiterbauelementes 10 mit Stegwellenleiterstruktur 4, in diesem Beispiel eines MCRW-Lasers, sind die lichtemittierenden Kanten (Spiegel) 2 des Bauelementes 10 unter Verwendung einer Maskierung in der gewünschten Struktur aus einem Halbleiterplättchen 1 herausgeätzt worden, das durch einen Epitaxieprozeß mit einer vom Bauelement 10 abhängigen Schichtenfolge versehen worden ist. In diesem Beispiel liegt von oben her folgende Schichtenfolge vor: Eine erste p-Kontakt-Metallisierung 11, darunter eine Zn-Diffusionszone 9 mit dem p-leitenden Bereich. Daran schließt sich die aktive Zone 7 des Lasers, d. h. der Resonatorbereich an. Darunter befinden sich die n-leitenden Schichten, wobei als Halbleiterplättchen 1 ein n-leitendes Substrat verwendet wird, das auf seiner Unterseite von einer nicht dargestellten n-Metallisierung abgeschlossen wird. Die naßchemisch oder trockenätztechnisch entstandenen, mit ihren nahezu senkrechten Seitenwänden teilweise die lichtemittierenden Kanten (Spiegel) 2 des Bauelementes 10 bildenden Ätzgräben 3 werden mit einer geeigneten ersten Fotolackschicht 5 zugedeckt. Die erste Fotolackschicht 5 wird im Bereich außerhalb des Ätzgrabens 3 belichtet und wegentwickelt. Der verbleibende Teil der ersten Fotolackschicht 5 wird bei einer solchen Temperatur ausgeheizt, daß er zwar lichtunemfindlich aber chemisch nicht unlöslich, zweckmäßig acetonlöslich, wird. Anschließend wird über die erste Fotolackschicht 5 eine zweite Fotolackschicht 6 aufgetragen. Diese zweite Fotolackschicht 6 wird in der gewünschten Struktur belichtet und entwickelt, so daß eine Stegwellenleiterätzmaske gebildet wird, wie das aus FIG 1 ersichtlich ist. Schließlich werden die mit der Maskierung vorgegebenen Stegwellenleiterstrukturen 4 aus dem Halbleiterplättchen 1 trockenätztechisch oder naßchemisch herausgeätzt. Auf diese Weise erhält man die in FIG 2 dargestellte Struktur. Die Schichtenfolge ist mit der in FIG 1 dargestellten identisch. Die Aluminiumoxidschicht (Al₂O₃-Schicht) 8 dient zur Beschichtung der Spiegel bzw. der lichtemittierenden Kanten 2 und schließt in FIG 2 die Stirnflächenbereiche der Stegwellenleiter 4 mit ein. Nach einer abschließend vorgenommenen zweiten Metallisierung 12 liegt im dargestellten Falle der MCRW-Lasertechnologie der vollständige p-Kontakt auf dem Halbleiterplättchen 1 vor.

Das erfindungsgemäße Verfahren ist auf das dargestellte Ausführungsbeispiel nicht beschränkt. Dieses Verfahren ist praktisch auf jede Form von lichtwellenführenden Strukturen anwendbar, die in monolithischer Technologie mit monolithisch hergestellten lichtkoppelnden Kanten verknüpft werden. Beispielsweise lassen sich mit dem erfindungsgemäßen Verfahren auch optische Wellenleiter oder Modulatoren auf Lithiumniobatbasis realisieren. Auch zum Herstellen von Richtkopplern ist das erfindungsgemäße Verfahren anwendbar, bei denen z. B. die Lichtleitfasern nach dem Prinzip der Stirnflächenkopplung mit einem Lithiumniobat-Chip verbunden sind und in V-förmigen, in Silizium geätzten Bahnen geführt werden. Ähnliche Kompontenten sind auch aus beispielsweise GaAlAs/GaAs herstellbar.

## Patentansprüche

1. Verfahren zum monolithischen Herstellen von stirnflächenkoppelbaren optoelektronischen und/oder optischen Bauelementen mit Stegwellenleiterstruktur, bei dem die lichtkoppelnden Kanten des Bauelementes unter Verwendung einer Maskierung in der gewünschten Struktur aus einem Plättchen aus geeignetem Material herausgeätzt werden, das durch einen oder mehrere Epitaxie-, Diffusions- und/ oder Implantationsprozesse mit einer vom Bauelement abhängigen Schichtenfolge versehen worden ist, **dadurch gekennzeichnet,** daß die naßchemisch oder trockenätztechnisch entstandenen, mit ihren nahezu senkrechten Seitenwänden teilweise die lichtkoppelnden Kanten (2) des Bauelementes (10) bildenden Ätzgräben (3) mit einer geeigneten ersten Schicht (5) aus organischem Material zugedeckt werden, daß die erste Schicht (5) aus organischem Material im Bereich außerhalb des Ätzgrabens (3) fototechnisch, durch Veraschen bzw. durch chemische Einwirkung entfernt wird, so daß der verbleibende Teil der ersten Schicht (5) den Ätzgraben (3) mindestens nahezu ausfüllt, daß dann eine zweite Schicht (6) aus organischem Material über die erste Schicht (5) aufgetragen wird, daß die zweite Schicht (6) aus organischem Material in der gewünschten Form strukturiert wird, so daß eine Stegwellenleiterätzmaske gebildet wird, und daß die mit der Maskierung vorgegebenen Stegwellenleiterstrukturen (4) aus dem Plättchen (1) trockenätztechnisch oder naßchemisch herausgeätzt werden.

2. Verfahren nach Anspruch 1, **dadurch gekennzeichnet,** daß das Plättchen (1) aus Glas, Silizium, III-V-Halbleitermaterial oder Lithiumniobat (LiNbO₃) besteht.

3. Verfahren nach Anspruch 1 oder 2, **dadurch gekennzeichnet,** daß die Schicht (5) aus organischem Material eine Fotolackschicht ist.

4. Verfahren nach Anspruch 1 zum monolithischen Herstellen von kantenemittierenden optoelektronischen Halbleiterbauelementen mit Stegwellenleiterstruktur, bei dem die lichtemittierenden Kanten des Bauelements unter Verwendung einer Maskierung in der gewünschten Struktur aus einem Halbleiterplättchen herausgeätzt werden, das durch einen Epitaxieprozeß mit einer für den Laserbetrieb geeigneten Schichtenfolge versehen worden ist, **dadurch gekennzeichnet,** daß die naßchemisch oder trockenätztechnisch entstandenen, mit ihren nahezu senkrechten Seitenwänden teilweise die lichtemittierenden Kanten (2) des Bauelements (10) bildenden Ätzgräben (3) mit einer geeigneten ersten Schicht (5) aus Fotolack zugedeckt werden, daß die erste Schicht (5) aus Fotolack im Bereich außerhalb des Ätzgrabens (3) belichtet und wegentwickelt wird, daß der verbleibende Teil der den Ätzgraben (3) mindestens nahezu ausfüllenden ersten Schicht (5) aus Fotolack bei einer solchen Temperatur ausgeheizt wird, daß er lichtunempfindlich aber nicht chemisch unlöslich wird, daß dann eine zweite Schicht (6) aus Fotolack über die erste Schicht (5) aus Fotolack aufgetragen wird, daß die zweite Schicht (6) in der gewünschten Struktur belichtet und entwickelt wird, so daß eine Stegwellenleiterätzmaske gebildet wird, und daß die mit der Maskierung vorgegebenen Stegwellenleiterstrukturen (4) aus dem Plättchen (1) aus Halbleitermaterial trockenätztechnisch oder naßchemisch herausgeätzt werden.

5. Verfahren nach einem der Ansprüche 1 bis 4, **dadurch gekennzeichnet,** daß das mit der Ätzgrabenstruktur (3) und der Stegwellenleiterstruktur (4) versehene Plättchen (1) aus Halbleitermaterial anschließend passiviert wird.

6. Verfahren nach einem der Ansprüche 1 bis 5, **dadurch gekennzeichnet,** daß die Oberfläche der Stegwellenleiter (4) mit einer zusätzlichen Metallisierung (12) versehen wird.

7. Verfahren nach einem der Ansprüche 1 bis 6, **dadurch gekennzeichnet**, daß zum Vereinzeln der Bauelemente (10) die zu schützenden Teile des Plättchens (1) mit einer Maskierung versehen werden, daß danach naßchemisch oder trockenätztechnisch in die Bodenflächen der Ätzgräben (3) eine weitere Grabenvertiefung eingeätzt wird, und daß anschließend die Bauelemente (10) durch Brechen direkt oder nach einem Zusatzschritt, wie Anritzen, Grabenätzen oder Sägen, getrennt werden.

8. Verfahren nach einem der Ansprüche 1 bis 7, **dadurch gekennzeichnet,** daß als Naßätzmittel eine 3:1:1-Ätze der Zusammensetzung 3H₂SO₄: 1H₂O₂: 1H₂O und/oder als Trockenätzmittel ein Chlorplasma verwendet wird.

## Claims

1. Method for the monolithic production of optoelectronic and/or optical components which can be end-fire coupled and have a rigid waveguide structure in which, using a mask in the desired structure, the light-coupling edges of the component are etched out from a wafer of suitable material which has been provided by one or more epitaxie, diffusion and/or implantation processes with a sequence of layers depending on the component, characterised in that etched trenches (3) produced using wet chemical or dry etching techniques and partially forming by means of their virtually perpendicular side walls light-coupling edges (2) of the component (10) are covered with a suitable first layer (5) made from organic material, in that the first layer (5) made from organic material is removed in the region outside the etched trench (3) phototechnically, by incineration or by chemical action, so that the remaining portion of the first layer (5) at least virtually fills up the etched trench (3), in that then a second layer (6) made from organic material is applied over the first layer (5), in that the second layer (6) made from organic material is structured in the desired shape so that a ridged waveguide etching mask is formed, and in that the ridged waveguide structures (4) specified by the mask are etched out from the wafer (1) using dry etching or wet chemical techniques.

2. Method according to Claim 1, characterised in that the wafer (1) comprises glass, silicon, III-V semiconductor material ir lithium niobate or (LiNbO₃).

3. Method according to Claim 1 or 2, characterised in that the layer (5) made from organic material is a photoresist layer.

4. Method according to Claim 1 for the monolithic production of etch-emitting optoelectronic semiconductor components having a rigid waveguide structure in which, using a mask in the desired structure, the light-emitting edges of the component are etched out from a semiconductor wafer which has been provided by an epitaxie process with a sequence of layers that is suitable for laser operation, characterised in that the etched trenches (3) produced using wet chemical or dry etching techniques and partially forming by means of their virtually perpendicular side walls the light-emitting edges (2) of the component (10) are covered with a suitable first layer (5) made from photoresist, in that the first layer (5) made from photoresist is exposed in the region outside the etched trench (3) and removed by development, in that the remaining portion of the first layer (5) made from photoresist and at least virtually filling up the etched trench (3) is heated at a temperature such that it becomes insensitive to light but not chemically insoluble, in that then a second layer (6) made from photoresist is applied over the first layer (5) made from photoresist, in that the second layer (6) is exposed and developed in the desired structure so that a ridged waveguide etching mask is formed, and in that the ridged waveguide structures (4) specified by the mask are etched out from the wafer (1) made from semiconductor material using dry etching or wet chemical techniques.

5. Method according to one of Claims 1 to 4, characterised in that the wafer (1) made from semiconductor material and provided with the etched trench structure (3) and the ridged waveguide structure (4) is subsequently passivated.

6. Mathod according to one of Claims 1 to 5, characterised in that the surface of the ridged waveguide (4) is provided with an additional metallisation (12).

7. Method according to one of Claims 1 to 6, characterised in that in order to separate the components (10) the parts of the wafer (1) that are to be protected are provided with a mask, in that a further trench depression is thereafter etched into the bottom surfaces of the etched trenches (3) using wet chemical or dry etching techniques, and in that the components (10) are subsequently separated by breaking directly or after an additional step, such as scratching, trench etching or sawing.

8. Method according to one of Claims 1 to 7, characterised in that a 3:1:1 etching solution of the composition 3H₂SO₄:1H₂O₂:1H₂O is used as wet etching agent and/or a chlorine plasma is used as dry etching agent.

## Revendications

1. Procédé de fabrication monolithique de composants optoélectroniques et/ou optiques, pouvant être couplés par leur faces frontales et possédant une structure de guide d'ondes à nervure, selon lequel on dégage par corrosion les bords, réalisant le couplage de la lumière, du composant en utilisant un masquage possédant la structure désirée, à partir d'une plaquette formée d'un matériau approprié, sur lequel on a déposé, au moyen d'un ou de plusieurs procédés d'épitaxie, de diffusion et/ou d'implantation, une suite de couches qui dépend du composant, caractérisé par le fait qu'on recouvre avec une première couche appropriée (5) formée d'un matériau organique? les sillons (3) formés par corrosion, qui ont été formés par voie chimique humide ou par une technique de corrosion à sec et qui forment, avec leurs parois latérales approximativement perpendiculaires, en partie les bords (2), qui réalisent le couplage de la lumière, du composant (10), qu'on élimine la première couche (5) de matériau organique par une technique photochimique, par brûlage ou par réaction chimique dans la zone située à l'extérieur du sillon (3) formé par corrosion, de sorte que la partie subsistante de la première couche (5) remplit au moins approximativement le sillon (3) formé par corrosion, qu'on dépose ensuite, sur la première couche (5), une seconde couche (8) formée d'un matériau organique, qu'on structure la seconde couche (6) formée d'un matériau organique en lui donnant la forme désirée de manière à constituer un masque de corrosion pour le guide d'ondes à nervure et qu'on élimine par corrosion, selon la technique de corrosion à sec ou par voie chimique humide, les structures (4) de guides d'ondes à nervure, prédéterminées par le masquage, à partir de la plaquette (1).

2. Procédé suivant la revendication 1, caractérisé par le fait que la plaquette (1) est formée de verre, de silicium, d'un matériau semiconducteur (III-V) ou de niobate de lithium (LiNbO₃).

3. Procédé suivant la revendication 1 ou 2, caractérisé par le fait que la couche (5) formée d'un matériau organique est une couche de photolaque.

4. Procédé suivant la revendication 1 pour la fabrication monolithique de composants optoélectroniques à semiconducteurs, qui émettent au niveau de leurs bords et qui possèdent une structure de guide d'ondes à nervure, selon lequel on dégage par corrosion les bords, qui émettent la lumière, du composant en utilisant un masquage correspondant à la structure désirée, à partir d'une plaquette semiconductrice, que l'on a recouverte au moyen d'un procédé épitaxial avec une suite de couches convenant pour le fonctionnement laser, caractérisé par le fait qu'on recouvre les sillons (3) formés par corrosion, qui sont obtenus par voie chimique humide ou au moyen d'une technique de corrosion à sec et qui forment, par leurs parois latérales approximativement perpendiculaires, en partie les bords (2) du composant (10), qui émettent une lumière, avec une première couche appropriée (5) formée d'une photolaque, qu'on expose et on élimine par développement la première couche de photolaque (5), dans la région située à l'extérieur du sillon (3) formé par corrosion, qu'on applique un recuit à la partie restante de la première couche (5) de photolaque, qui remplit au moins approximativement le sillon (3) formé par corrosion, à une température telle que cette couche devient insensible à la lumière, mais pas chimiquement insoluble, qu'on dépose ensuite une seconde couche (6) de photolaque sur la première couche (5) de photolaque, qu'on expose et on développe la seconde couche (6) avec la structure désirée, de manière à former un masque de corrosion du guide d'ondes à nervure et qu'on élimine par corrosion, selon une technique de corrosion à sec par voie chimique humide, les structures (4) du guide d'ondes à nervure, prédéterminées au moyen du masquage, à partir de la plaquette (1) formée d'un matériau semiconducteur.

5. Procédé suivant l'une des revendications 1 à 4, caractérisé par le fait qu'on applique ensuite une passivation à la plaquette (1) formée d'un matériau semiconducteur, qui est pourvue de la structure en forme de sillon formée par corrosion (3) et de la structure (4) du guide d'ondes à nervures.

6. Procédé suivant l'une des revendications 1 à 5, caractérisé par le fait qu'on équipe la surface du guide d'ondes à nervure (4), d'une métallisation supplémentaire (12).

7. Procédé suivant l'une des revendications 1 à 6, caractérisé par le fait que pour séparer les composants (10), on applique un masquage aux parties de la plaquette (1) devant être protégées, qu'ensuite on aménage par corrosion, par voie chimique humide ou selon une technique de corrosion à sec, un autre renfoncement pour former un sillon, dans la surface du fond des sillons (3) formés par corrosion, et qu'ensuite on sépare les composants (10) par rupture directement ou après une étape supplémentaire, comme par exemple par fendage, corrosion de sillons ou sciage.

8. Procédé suivant l'une des revendications 1 à 7, caractérisé par le fait qu'on utilise comme agent de corrosion humide, un bain corrosif 3:1:1 ayant pour composition 3H₂SO₄:1H₂O₂:1H₂O et/ou, en tant qu'agent corrosif à sec, un plasma de chlore.
